# EUROPEAN PATENT SPECIFICATION

(11) **EP 4 062 460 B1**
(45) Date of publication and mention of the grant of the patent: **21.10.2026**
(21) Application number: 20889666.2
(22) Date of filing: 18.11.2020
(51) Int. Cl.: H10H 20/00, H04B 10/80, H10H 20/816, H10H 20/819, H10W 90/00, H10H 20/825

(54) **HIGH SPEED AND MULTI-CONTACT LEDS FOR DATA COMMUNICATION**
HOCHMODULATIONSGESCHWINDIGKEITS- UND MEHRKONTAKT-LED FÜR DATENKOMMUNIKATION
DEL À GRANDE VITESSE DE MODULATION ET MULTICONTACT POUR COMMUNICATION DE DONNÉES

(30) Priority: 18.11.2019 US 201962936767 P; 07.02.2020 US 202062971844 P
(43) Date of publication of application: 28.09.2022
(73) Proprietor: Avicenatech, Corp., Sunnyvale, CA 94089 (US)
(72) Inventor: PEZESHKI, Bardia, Sunnyvale, California 94089 (US); KALMAN, Robert, Sunnyvale, California 94089 (US); TSELIKOV, Alex, Sunnyvale, California 94089 (US)
(74) Representative: Derry, Paul Stefan
(86) International application number: PCT/US2020/061101
(87) International publication number: WO 2021/102034

(56) References cited:
- JP-A- 2013 168 507
- US-A- 5 003 366
- US-A1- 2014 001 483
- US-A1- 2014 023 376
- US-A1- 2015 243 648
- US-A1- 2015 349 200
- FENG M ET AL: "Quantum-well-base heterojunction bipolar light-emitting transistor", APPLIED PHYSICS LETTERS, AMERICAN INSTITUTE OF PHYSICS, 2 HUNTINGTON QUADRANGLE, MELVILLE, NY 11747, vol. 84, no. 11, 15 March 2004 (2004-03-15), pages 1952 - 1954, XP012060799, ISSN: 0003-6951, DOI: 10.1063/1.1669071
- DUTTA SATADAL ET AL: "Monolithic optical link in silicon-on-insulator CMOS technology", vol. 25, no. 5, 28 February 2017 (2017-02-28), pages 5440, XP093102220, Retrieved from the Internet <URL:https://opg.optica.org/directpdfaccess/38e2081f-e7fc-41c8-86f79e6666e61141_360465/oe-25-5-5440.pdf?da=1&id=360465&seq=0&mobile=no> DOI: 10.1364/OE.25.005440
- CARLOS MEDINA, MAYTEÉ ZAMBRANO, KIARA NAVARRO: "LED BASED VISIBLE LIGHT COMMUNICATION: TECHNOLOGY, APPLICATIONS AND CHALLENGES - A SURVEY", INTERNATIONAL JOURNAL OF ADVANCES IN ENGINEERING & TECHNOLOGY, I A E T PUBLISHING COMPANY, BAREILLY, 1 August 2015 (2015-08-01), Bareilly, pages 482 - 482, XP055313225, Retrieved from the Internet <URL:http://www.ijaet.org/media/4I28-IJAET0828241-v8-iss4-482-495.pdf>

## Description

### FIELD OF THE INVENTION

The present invention relates generally to light emitting diodes (LEDs), and more particularly to high speed LEDs for data communications.

### BACKGROUND OF THE INVENTION

Lasers tend to dominate optical communications on account of their narrow linewidth, single spatial mode output, and high-speed characteristics. The narrow linewidth of a laser means that high speed signals can pass through dispersive mediums for long distances without pulse broadening. Long distance fiber optic links are frequently limited by chromatic dispersion and thus a narrow linewidth laser may be essential for long distance fiber optic links. The single spatial mode of a laser is also relatively easy to couple to single mode fiber.

The stimulated emission of lasers may also allow for high modulation speeds. Directly modulated optical links may be able to run at 25 Gb/s easily, and potentially carry 50 Gb/s of information using PAM4 modulation.

However, use of lasers may present difficulties for optical communications for very short distances, such as chip-to-chip communications.

US 2014/023376 A1 discloses establishing a communication link between a first location and a second location by providing a tilted charge light emitting device at the first location and coupled with the driver circuit such that the light produced by the tilted charge light-emitting device is a function of the input data; providing an optical fiber between the first and second locations; coupling light from the tilted charge light emitting device into the optical fiber; and providing, at the second location, a photodetector coupled with the optical fiber and with the receiver circuit; whereby electrical signals representative of the input data are output from the receiver circuit.

Feng, M. et al. "Quantum-Well-Base heterojunction bipolar light-emitting transistor" discloses incorporating InGaAs quantum wells in the base layer of light-emitting InGaP/GaAs heterojunction bipolar transistors (LETs) operating in the common-emitter configuration. Two 50A In1_xGaxAs (x=85%) quantum wells (QWs) acting as electron capture centers are imbedded in the 300 A GaAs base layer, thus improving the light emission intensity compared to a similar LET structure without QW s in the base.

Dutta, S. et al. "Monolithic Optical link in Silicon-on-insulator CMOS technology" discloses a monolithic laterally-coupled wide-spectrum optical link in a silicon-on-insulator CMOS technology. The link consists of a silicon (Si) light-emitting diode (LED) as the optical source and a Si photodiode (PD) as the detector; both realized by vertical abrupt n+p junctions, separated by a shallow trench isolation composed of silicon dioxide. Medium trench isolation around the devices along with the buried oxide layer provides galvanic isolation.

JP 2013 168507 A discloses a nitride semiconductor light-emitting transistor which is made of a nitride semiconductor and has a structure of a pnp double heterojunction bipolar transistor is characterized in that, in an n-type base layer having a lattice constant larger than that of a collector layer, a quantum well layer is inserted closer to the collector layer than the center of the base layer.

### BRIEF SUMMARY OF THE INVENTION

The matter for protection is defined by the claims.

Disclosed but not the subject of the claims is an optical communication system for communicating information provided by a processor to another area of the processor or another module in a multi-chip module, comprises: an LED associated with the processor; an LED driver for activating the LED to generate light based on data provided to the LED driver from the processor; a detector for performing optical-electrical conversion using the light; and an optical waveguide optically coupling the LED and the detector; wherein the LED comprises: a bipolar junction transistor (BJT) with a base including quantum wells. An emitter of the BJT may comprise AlGaN.

The specification discloses an optical communication system for communicating information provided by a processor to another area of the processor or another module in a multi-chip module, comprises: an LED associated with the processor; an LED driver to modulate the output optical power of the LED, such that the LED will generate light based on data provided to the LED driver from the processor; a detector for performing optical-electrical conversion using the light, the detector for example having an electrical output that is modulated by optical power incident on the detector; and an optical waveguide optically coupling the LED and the detector; wherein the LED comprises: a p-n junction with a metal oxide semiconductor (MOS) structure as defined by claim 1.

Aspects of the invention are more fully comprehended upon review of this disclosure.

### BRIEF DESCRIPTION OF THE FIGURES

Fig. 1A shows an electrically controllable LED fabricated with an extra contact, in accordance with aspects of the invention, Fig. 1B shows a band diagram for an on state of the LED, and Fig. 1C shows a band diagram for an off state of the LED.
Fig. 2 shows an electrically controllable LED fabricated with an extra contact, with an AlGaN emitter.
Fig. 3 shows an LED structure with an extra contact, that combines a p-n junction with a MOS structure that can sweep out the minority carriers, but collect them in an accumulation region, in accordance with aspects of the invention.
Fig. 4 shows an LED structure with an extra contact, that includes a lateral accumulation region, in accordance with aspects of the invention.
Fig. 5 shows an example of use of a LED as variously discussed herein, in accordance with aspects of the invention.

### DETAILED DESCRIPTION

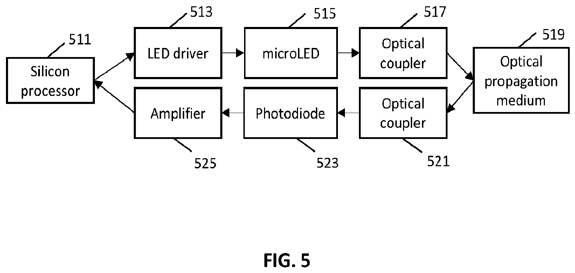

The characteristics of lasers may not be as important for optical communications for very short distances, such as chip-to-chip communications. In some embodiments microLEDs, especially structures optimized for high modulation speeds, are used for coupling light into waveguides, for example as discussed with respect to Fig. 5. In some embodiments use of the microLEDs provide highly parallel communications between chips, for example on an interposer or through a 3D optical structure, for example an optical structure that includes optical waveguides and/or free-space optical propagation with optical elements such as lenses and holograms. GaN based microLEDs have been developed for display applications and a packaging ecosystem has been developed for mounting such devices on silicon CMOS or polysilicon-on-glass backplanes. With relatively minor modifications, elements of such a packaging eco-system may be used to interconnect ICs for chip-to-chip communications.

In some embodiments a microLED is distinguished from a semiconductor laser (SL) as follows: (1) a microLED does not have an optical resonator structure; (2) the optical output from a microLED is almost completely spontaneous emission, whereas the output from a SL is dominantly stimulated emission; (3) the optical output from a microLED is temporally and spatially incoherent, whereas the output from a SL has significant temporal and spatial coherence; (4) a microLED is designed to be driven down to a zero minimum current, whereas a SL is designed to be driven down to a minimum threshold current, which is typically at least 1mA. In some embodiments a microLED is distinguished from a standard LED by (1) having an emitting region of less than 100 micrometers by 100 micrometers (less than 100 um x 100 um in some embodiments); (2) frequently having positive and negative contacts on top and bottom surfaces, whereas a standard LED typically has both positive and negative contacts on a single surface; (3) typically being used in large arrays for display and interconnect applications.

In some embodiments, for chip to chip communications, the distances are so short that chromatic dispersion is not necessarily a problem. Simple calculations indicate that, for a GaN LED with a center wavelength in the range of 400 nm - 450 nm and a 20 nm spectral width, if the LED is modulated at 4 Gb/s and propagates through a doped SiO₂ waveguide or fiber, the waveguide or fiber can be up to 5 meters long with a dispersion power penalty less than 2 dB. Since chip to chip communication distances within a multi-chip module (MCM) or across a PC board are typically less than tens of centimeters, the broad spectral width of an LED may not be an issue. Furthermore, one can even use highly multi-moded waveguides into which it is relatively easy to couple the output light from an LED. Since the distances are short, modal dispersion of multimode waveguides may again not be an issue. At a 4 Gb/s signal rate, even in a waveguide with a 10% core-cladding index step that has an NA of 0.67, the waveguide length can be up to 85 cm with a small dispersion power penalty; smaller core-cladding index steps generally have longer reach. So broad spectrum LEDs and multi-mode waveguides are adequate in many embodiments for chip to chip communications.

Furthermore, in various embodiments the microLEDs are fabricated at very small sizes, with device dimensions of less than 2 um. Such a small mode has very high intrinsic brightness (i.e. low etendue) and generally can be easily coupled to a multimode waveguide. Though the output is generally Lambertian, with proper use of reflectors, microlenses in some embodiments, and imbedding the microLED in waveguide in some embodiments, coupling efficiencies can be 30% or more. MicroLEDs typically have high quantum efficiencies, similar or even surpassing lasers. Since over short distances one does not suffer much loss, even at the blue or green wavelengths, not much transmit power is required and a small microLED can be sufficient, running at a 10 uA or so in some embodiments.

A microLED in general is limited by the carrier lifetime (and by capacitance if the microLED is too big), and generally cannot achieve the modulation speeds of high-speed lasers. However, clock speeds in microprocessors and logic seem to be reaching a limit of a few Gb/s and data coming in and out of ICs are typically sped up using serializer/deserializers (SERDES) to produce a smaller number of higher speed lanes. For example, commercially available switch ICs may currently run at a few GHz clock speed, but communicate with 256 or 512 lanes of 50 Gb/s or 100 Gb/s per lane, where each lane has an associated SERDES. These SERDES consume a great deal of electrical power and can be eliminated if the switch IC instead uses a larger number of lower speed lanes. Optics allows that parallelism and would enable much higher throughput, even at slower lane speeds by having a much larger number of lanes. Nevertheless, LEDs that operate at modulation speeds that are as high as possible may be preferred.

Furthermore, GaN microLEDs have substantial advantages over lasers in that they do not have a significant threshold current. Though quantum efficiency is a function of drive current, there is not a discrete threshold level for microLEDs, and moreover, microLEDs can be run at far lower currents than lasers. Given their usefulness for displays, there is a substantial infrastructure for mounting, connecting, and testing microLEDs on various substrates. And GaN microLEDs generally have far superior high temperature performance and reliability over semiconductor lasers.

Typically, a GaN microLED, optimized for display applications, comprises a cylindrical or cylindrical-like structure with a p-i-n doping profile. The LED is turned on by forward biasing the diode and injecting electrons from the n-region and holes from the p-region into the middle intrinsic region that contains InGaN quantum wells. A p contact is on one side of the structure, while an n contact is on the other. In many applications the device is mounted onto a chip, where a "bottom" side electrically contacts the chip, and a "top" side contacts a common lead (e.g. a ground or power lead). The top side contact may be a transparent conductor such as indium-tin oxide (ITO). In microLEDs the vertical structure is often preferred, but there are also lateral structures, or an n-contact that is adjacent to the p-contact. In any case, this structure is not optimized for speed, simply because displays typically run at 60 Hz or 120 Hz frame rate, not at Gb/s.

There are changes that one can do to optimize the structure for speed. In general, a microLED is limited by the capacitance of the LED and the carrier recombination time (or diffusion capacitance). The capacitance forms an RC circuit with the drive output impedance and causes a roll-off at high frequencies. The carrier lifetime means that the LED takes time to turn off, as one has to wait for the minority injected carriers to recombine for the light emission to cease, even after the electrical pulse has ended. Due to their small size, the capacitance of microLEDs, generally just a few femto-Farads, does not significantly limit device modulation speed; rather, modulation speed is generally limited by carrier lifetime.

Generally the speed of a microLED increases with injected current density. There are three ways that carriers can recombine in LEDs. At low current levels, the recombination is mediated by traps (SRH recombination). At higher current densities these traps become saturated and the quantum efficiency of the LED improves, as radiative recombination dominates. This radiative recombination rate speeds up as the carrier density increases, increasing the radiative efficiency and reducing the carrier lifetime. Thus the harder (e.g. greater current densities) the microLEDs are driven, the faster they operate. At high current densities, nonlinear non-radiative mechanisms such as Auger recombination further reduce carrier lifetime, but these non-radiative mechanisms also reduce the radiative quantum efficiency. For a fast microLED with a small diameter driven with a high current density, the traps are relatively unimportant as they are saturated, and the relative significance of nonlinear non-radiative versus radiative recombination rate determines the quantum efficiency.

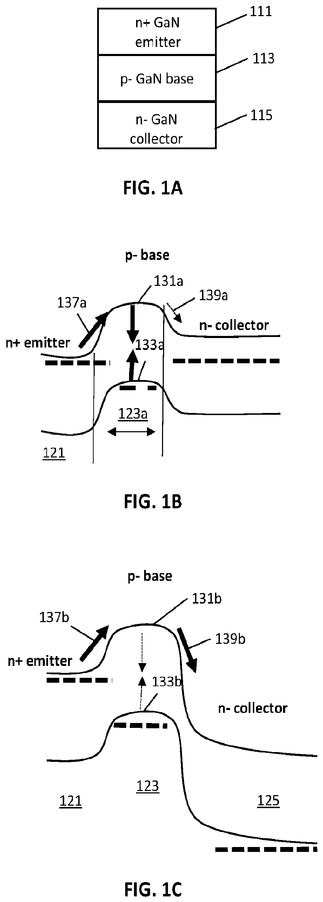

There are structural changes that can be made to a microLED to improve speed. In some embodiments an electrically controllable LED is fabricated with an extra contact. One possible configuration is to have the light emission occur in the base of an LED that is in the general form of a bipolar junction transistor, which has base, emitter, and collector regions, each with an associated electrical contact. The base-emitter junction may be forward biased with the emitter injecting carriers into the base and recombining so that light is emitted from the base region. For light emission, the transistor may be biased into saturation, with the collector unbiased. To turn the LED off rapidly, the collector is reverse biased, sweeping the minority carriers out of the base. Fig. 1A shows this structure, along with band diagrams for an on state and an off state in Fig. 1B and 1C, respectively.

As shown in Fig. 1A, in embodiments that are not the subject of the claims, an LED includes an n+ GaN emitter 111 and an n- GaN collector. A p- GaN base region 113 is between the emitter and the collector. The base region includes quantum wells.

The band diagram of Fig. 1B is for the LED of Fig. 1A in the on state. The band diagram of Fig. 1B shows a conduction band 131a above a valence band 133a. The bands extend across an emitter region 121, a base region 123, respectively, and a collector region 125. A bandgap between the conduction band and the valence band is generally constant across each region, with energy levels generally increasing in the recombination region between the emitter and base regions, and energy levels dropping somewhat in the collector region. In the "on" state, electrons are injected 137a from the emitter region into the base region where most of them recombine; the remaining electrons that have not recombined are swept out 139a from the base region into the collector region, as indicated by the relative size of arrows in FIG. 1B.

The band diagram of Fig. 1C is for the LED of Fig. 1A in the "off" state. As with the band diagram of Fig. 1B, the band diagram of Fig. 1C shows a conduction band 131b above a valence band 133b, extending across the emitter region 121, the base region 123, and the collector region 125. In the "off" state, electrons are injected 137b from the emitter region into the base region. Unlike in the "on" state, however, in the "off" state a significant fraction of electrons are swept out 139b from the base region into the collector region, again as indicated by the relative size of arrows in FIG. 1C.

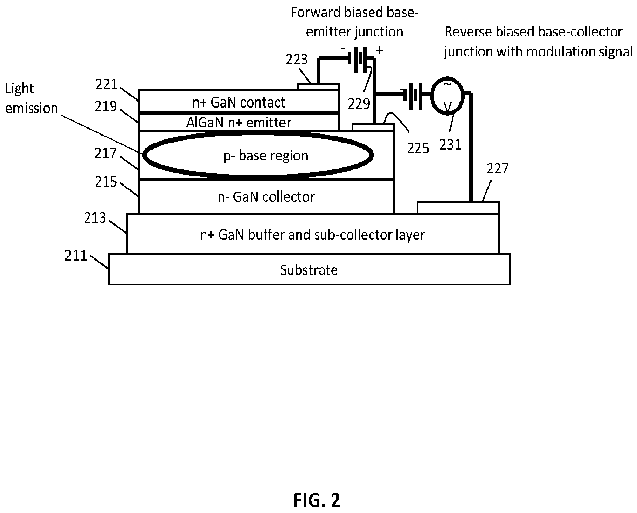

A further enhancement would be to have the emitter region made from AlGaN for better injection into the base region. In some embodiments the AlGaN acts as a barrier on the n region to further enhance injection of carriers into the p doped base region and prevent hole injection into the n type region. In 3D the structure may be in the form shown in the schematic cross-section of Fig. 2.

Fig. 2 shows an n+ GaN buffer and sub-collector layer 213 on top of a substrate 211. The substrate could be silicon, GaN, or most commonly used, sapphire. An n- GaN collector layer 215 is on top of a first portion of the sub-collector layer, while a collector electrical contact 227 is on top of a second portion of the sub-collector layer. A p- base region layer 217 is on top of the collector layer. In many embodiments the p- base region layer includes one or more quantum wells. In operation, light may be emitted by the base region layer. An AlGaN n+ emitter layer 219 is on top of a first portion of the base region layer, while a base electrical contact 229 is on top of a second portion of the base layer. The AlGaN n+ emitter layer separates the base region layer and a n+ GaN contact layer 221, which is on top of the AlGaN n+ emitter layer. An emitter electrical contact 223 is on top of a portion of the n+ GaN contact layer.

The base-emitter junction can be forward biased through application of a voltage 229, injecting holes into the base. But the electron concentration in the base would be controlled by the base-collector voltage, where a negative bias would sweep out the carriers. Thus the base-collector junction would be reverse biased and a modulation signal 231 applied. This structure would be much faster than an LED since the turn-off time is no longer limited by the intrinsic carrier lifetime, but is instead determined by the speed with which the electric field in the base-collector removes carriers from the base region. However, this speed-up may come at the cost of reduced quantum efficiency because carriers that are removed from the base region cannot recombine to generate photons.

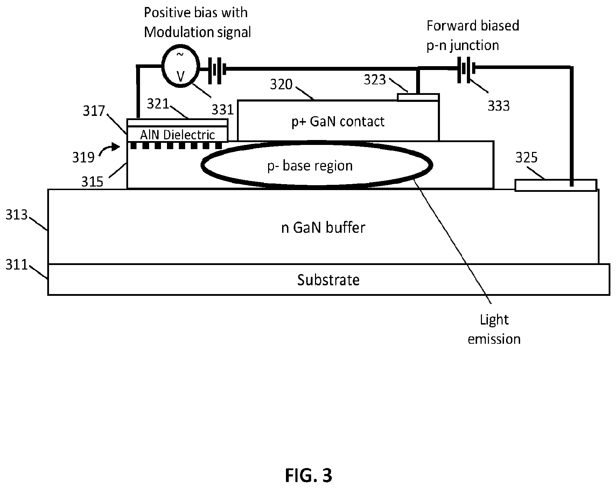

An alternative structure, which is used in an optical communication system according to the claims, is to combine a p-n junction with a MOS structure that can sweep the minority carriers from the base into an accumulation region. Laterally, the structure may be in form shown in the schematic cross-section of Fig. 3, if fabricated on a planar surface. In Fig. 3, an n type GaN buffer layer 313 is shown on a substrate 311. A p- base region layer 325 is on top of a first portion of the n type GaN layer, with an electrical contact 323 on top of a second portion of the n type GaN layer The n type GaN (with potentially an AlGaN barrier layer between it and the base layer in some embodiments) would inject electrons into a p- base region. These minority electrons would recombine in the base region with the local hole population to generate light.

A p+ GaN contact layer is on top of a first portion of the p- base region layer and a metal-oxide-semiconductor (MOS) structure, provided by a dielectric, for example aluminum nitride (AlN) 317, with an electrical contact 321 on top, is on top of a second portion of the p-base region layer. The MOS structure is close to the recombination region where a positive bias on the gate would pull the injected carriers into an accumulation region 319 under the MOS dielectric and turn off the light emission. Removing this voltage or making it slightly negative would force the carriers back into the base region where the carriers would recombine and give off light. Thus the injected electrons are not removed from the system, but are instead "recycled" for greater quantum efficiency compared to a transistor structure.

The structure in Fig. 3 generally has the accumulation region close to the base region, as the modulation speed of the device is related to the speed with which carriers can be swept between the two regions. In fact, the response time generally may depend on the size of the separation distance of the base and accumulation regions, and on the electric field (mobility) or saturation velocity, vₛₐₜ. In GaN, the saturation velocity of electrons is 1.4x10⁷ cm/s, so one may use a spacing of < 10um to achieve at least a 4 GHz modulation speed. This is easily achievable with a microLED diameter in the range of 2 um.

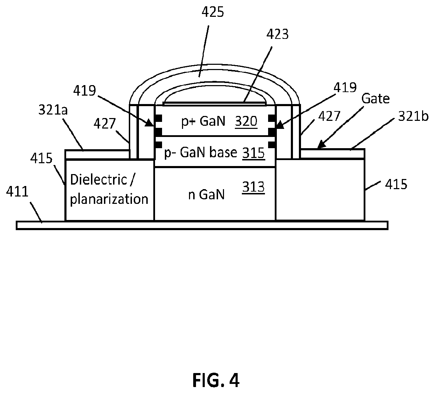

Fig. 4 shows an alternate MOS device geometry, which is used in an optical communication system according to the claims, where the MOS dielectric layer 425 is formed around the circumference of the microLED and can result in higher speeds. In the schematic the LED is bonded to a metal base 411 that provides an n- contact. An n GaN buffer layer 313 is on the metal base. An insulating layer 415, also bonded to the metal base, is on at least opposing sides of the buffer layer. The insulating layer extends slightly above a top of the buffer layer, on which may be found a p- GaN base region layer 315. A p+ GaN layer 320 is on top of the base layer. A p contact 423, for example a transparent p contact, is on top of the p+ GaN layer. The MOS dielectic layer is formed around the sides of the base region layer, and also around sides of the p+ GaN layer, with metallization 427 around the outward sides of the MOS dielectric layer. Accumulation regions 419 are in parts of the base region adjacent to the AlN. The insulating layer 415 serves as a stop from placement, for example by deposition, of the MOS dielectric and metallization about the n GaN buffer layer. The lateral deposition of dielectric and metallization around the sides may be considered to act as the MOS structure.

Fig. 5 shows an example, within the scope of the claims, of use of an LED, which may be a microLED 515, as variously discussed herein in relation to Fig. 3 or Fig. 4. In Fig. 5, a silicon processor 511 performs various operations on or with data. For example, the silicon processor may perform calculations on data, may perform switching functions, or may perform other functions. The silicon processor provides at least some of the data to an LED driver 513, with the LED driver activating the microLED to generate light with a power level that is modulated by at least some of the data. The generated light is provided to an optical coupler 517, which passes the light into an optical propagation medium 519. The optical propagation medium, which is a waveguide, may be used to transfer the light from one area of the silicon processor to another area of the silicon processor in some embodiments. In other embodiments, the optical propagation medium may be used to transfer light from the silicon processor to another silicon processor, or memory, or other module, for example in a multi-chip module (not shown in FIG. 5). The optical propagation medium may transfer the light to another optical coupler 521, which in turn passes the light to a detector 523, for example a photodiode, for optical-electrical conversion. The electrical signal from the detector output, including the at least some of the data, may be amplified by an amplifier 525, and provided to the silicon processor (or other chip in a multi-chip module). In some embodiments the microLEDs and detectors can be coupled to waveguides individually, and/or in some embodiments they may be coupled in parallel as arrays. The optical waveguides, in addition to transferring the light and the data from one position to another could also split the light into two or more outputs, allowing data fanout. The optical waveguides or medium could also perform some switching directing the output from one receiver to another receiver.

The microLEDs and detectors can be coupled to waveguides either individually or in parallel as arrays.

Although the invention has been discussed with respect to various embodiments, it should be recognized that the matter for protection is defined by the claims.

## Claims

1. An optical communication system for communicating information provided by a processor (511) to another area of the processor or another module in a multi-chip module, comprising:
an LED (515) associated with the processor;
an LED driver (513) for activating the LED to generate light that is modulated based on data provided to the LED driver from the processor;
a detector (523) for performing optical-electrical conversion using the light; and
an optical waveguide (519) optically coupling the LED and the detector;
wherein the LED comprises:
a p-n junction with a metal oxide semiconductor, MOS, structure;
wherein the p-n junction with a MOS structure comprises:
a n doped GaN buffer layer (313);
a p- base layer (315) on at least a portion of the n doped GaN buffer layer;
a p+ GaN contact layer (320) on a first portion of the p- base layer;
a dielectric layer (317) in contact with a second portion of the p- base layer; and
a metal layer in contact with the dielectric layer.

2. The system of claim 1, wherein the dielectric layer is on a second portion of the p- base layer.

3. The system of claim 1, wherein the second portion of the p- base layer is on at least one side of the p- base layer.

4. The system of claim 1, further comprising:
a further LED associated with the other area of the processor or other chip in the multi-chip module;
a further LED driver for activating the further LED to generate light that is modulated based on data provided to the further LED driver from the further area of the processor or other chip in the multi-chip module; and
a further detector for performing optical-electrical conversion using the light from the further LED;
wherein the further LED comprises:
a further p-n junction with a metal oxide semiconductor, MOS, structure;
wherein the further p-n junction with a MOS structure comprises:
a further n doped GaN buffer layer;
a further p- base layer on at least a portion of the n doped GaN buffer layer;
a further p+ GaN contact layer on a first portion of the p- base layer;
a further dielectric layer in contact with a second portion of the p- base layer; and
a further metal layer in contact with the dielectric layer.

## Patentansprüche

1. Optisches Kommunikationssystem zum Kommunizieren von Informationen, die durch einen Prozessor (511) bereitgestellt werden, an einen anderen Bereich des Prozessors oder ein anderes Modul in einem Mehrchipmodul, umfassend:
eine LED (515), die dem Prozessor zugeordnet ist;
einen LED-Treiber (513) zum Aktivieren der LED, um Licht zu erzeugen, das auf Grundlage von Daten moduliert wird, die dem LED-Treiber von dem Prozessor bereitgestellt werden;
einen Detektor (523) zum Durchführen einer optisch-elektrischen Umwandlung unter Verwendung des Lichtes; und
einen optischen Wellenleiter (519), der die LED und den Detektor optisch koppelt;
wobei die LED Folgendes umfasst:
einen P-N-Übergang mit einer Metalloxid-Halbleiterstruktur, MOS-Struktur;
wobei der P-N-Übergang mit einer MOS-Struktur Folgendes umfasst:
eine n-dotierte GaN-Pufferschicht (313);
eine p-Basisschicht (315) auf mindestens einem Abschnitt der n-dotierten GaN-Pufferschicht;
eine p+ GaN-Kontaktschicht (320) auf einem ersten Abschnitt der p-Basisschicht;
eine dielektrische Schicht (317) in Kontakt mit einem zweiten Abschnitt der p-Basisschicht; und
eine Metallschicht in Kontakt mit der dielektrischen Schicht.

2. System nach Anspruch 1, wobei sich die dielektrische Schicht auf einem zweiten Abschnitt der p-Basisschicht befindet.

3. System nach Anspruch 1, wobei sich der zweite Abschnitt der p-Basisschicht auf mindestens einer Seite der p-Basisschicht befindet.

4. System nach Anspruch 1, ferner umfassend:
eine weitere LED, die dem anderen Bereich des Prozessors oder anderen Chips in dem Mehrchipmodul zugeordnet ist;
einen weiteren LED-Treiber zum Aktivieren der weiteren LED, um Licht zu erzeugen, das auf Grundlage von Daten moduliert wird, die dem weiteren LED-Treiber von dem weiteren Bereich des Prozessors oder anderen Chip in dem Mehrchipmodul bereitgestellt werden; und
einen weiteren Detektor zum Durchführen einer optisch-elektrischen Umwandlung unter Verwendung des Lichtes von der weiteren LED;
wobei die weitere LED Folgendes umfasst:
einen weiteren P-N-Übergang mit einer Metalloxid-Halbleiterstruktur, MOS-Struktur;
wobei der weitere P-N-Übergang mit einer MOS-Struktur Folgendes umfasst:
eine weitere n-dotierte GaN-Pufferschicht;
eine weitere p-Basisschicht auf mindestens einem Abschnitt der n-dotierten GaN-Pufferschicht;
eine weitere p+ GaN-Kontaktschicht auf einem ersten Abschnitt der p-Basisschicht;
eine weitere dielektrische Schicht in Kontakt mit einem zweiten Abschnitt der p-Basisschicht; und
eine weitere Metallschicht in Kontakt mit der dielektrischen Schicht.

## Revendications

1. Système de communication optique destiné à communiquer des informations fournies par un processeur (511) à une autre zone du processeur ou à un autre module dans un module multipuce, comprenant :
une DEL (515) associée au processeur ;
un pilote de DEL (513) destiné à activer la DEL afin de générer une lumière qui est modulée sur la base des données fournies au pilote de DEL par le processeur ;
un détecteur (523) destiné à effectuer une conversion optique-électrique à l'aide de la lumière ; et
un guide d'onde optique (519) couplant optiquement la DEL et le détecteur ;
dans lequel la DEL comprend :
une jonction p-n avec une structure de semi-conducteur à oxyde métallique, MOS ;
dans lequel la jonction p-n avec une structure MOS comprend :
une couche tampon de GaN dopé n (313) ;
une couche de base p- (315) sur au moins une partie de la couche tampon de GaN dopé n ;
une couche de contact p+ GaN (320) sur une première partie de la couche de base p- ;
une couche diélectrique (317) en contact avec une seconde partie de la couche de base p ; et
une couche métallique en contact avec la couche diélectrique.

2. Système selon la revendication 1, dans lequel la couche diélectrique est sur une seconde partie de la couche de base p-.

3. Système selon la revendication 1, dans lequel la seconde partie de la couche de base p- est sur au moins un côté de la couche de base p-.

4. Système de la revendication 1, comprenant en outre :
une DEL supplémentaire associée à l'autre zone du processeur ou à une autre puce dans le module multipuce ;
un pilote de DEL supplémentaire destiné à activer la DEL supplémentaire afin de générer une lumière qui est modulée sur la base des données fournies au pilote de DEL supplémentaire à partir de la zone supplémentaire du processeur ou d'une autre puce dans le module multipuce ; et
un détecteur supplémentaire destiné à effectuer une conversion optique-électrique à l'aide de la lumière provenant de la DEL supplémentaire ;
dans lequel la DEL supplémentaire comprend :
une jonction p-n supplémentaire avec une structure de semi-conducteur à oxyde métallique, MOS ;
dans lequel la jonction p-n supplémentaire avec une structure MOS comprend :
une couche tampon de GaN dopé n supplémentaire ;
une couche de base p- supplémentaire sur au moins une partie de la couche tampon de GaN dopée n ;
une couche de contact p+ GaN supplémentaire sur une première partie de la couche de base p- ;
une couche diélectrique supplémentaire en contact avec une seconde partie de la couche de base p- ; et
une couche métallique supplémentaire en contact avec la couche diélectrique.
